# EUROPEAN PATENT APPLICATION

(11) **EP 4 040 369 A1**
(43) Date of publication of application: **10.08.2022**
(21) Application number: 20872499.7
(22) Date of filing: 02.10.2020
(51) Int. Cl.: G06Q 50/04

(54) **MANUFACTURING ORDER PLACEMENT SUPPORT DEVICE, METHOD, AND PROGRAM**

(30) Priority: 02.10.2019 JP 2019182308
(71) Applicant: NTT Communications Corporation, Tokyo 100-8019 (JP)
(72) Inventor: AKABORI, Hideaki, Tokyo 100-8019 (JP); YAMAKAWA, Kazuhiro, Tokyo 100-8019 (JP); KITA, Yujiro, Tokyo 100-8019 (JP)
(74) Representative: Gramm, Lins & Partner Patent- und Rechtsanwälte PartGmbB
(86) International application number: PCT/JP2020/037568
(87) International publication number: WO 2021/066151

(57) **Abstract**

The manufacturing ordering assistance apparatus, method and program according to the first embodiment of the present embodiment are configured such that the manufacturing ordering assistance apparatus capable of transmitting data by way of a network between a first terminal used by a product manufacturer and second terminals used by parts manufacturers acquires design information of a product from the first terminal; identifies information relating to parts from the acquired design information; generates, for the respective parts, parts manufacturing information necessary to manufacture the parts based on the identified information relating to the parts; and selects a parts manufacturer as an order recipient for the respective parts based on the generated parts manufacturing information and information relating to manufacturing capacities of the parts manufacturers.

## Description

### FIELD

Embodiments described herein relate to a manufacturing ordering assistance apparatus, a method and a program for assisting in manufacturing- and ordering-related operations of a product manufacturer.

### BACKGROUND

In general, a manufacturer who manufactures industrial products creates design drawings of a product on a design system using computer-aided design (CAD) or the like, creates a parts list or the like based on the created design drawings, selects a processing agent or procurement agent for each part based on this parts list, and places an order with them for the part. In order to automate these tasks, a technique of installing on the CAD design system a software program, for example for creating the above parts list and placing orders, has been suggested (see, for example, Patent Literature 1).

### CITATION LIST

### PATENT LITERATURE

[Patent Literature 1] Jpn. Pat. Appln. KOKAI Publication No. 2002-189758

### SUMMARY

### TECHNICAL PROBLEM

With the technique described in Patent Literature 1, however, the CAD design system is equipped with a parts list creating function and a parts order placing function, which increases the processing load on the CAD design system and also increases costs. In addition, product manufacturers need to individually acquire the information relating to available parts from parts manufacturers or providers, establish initial settings for the parts list creating function and parts order placing function on the CAD design system, and regularly update the settings, which requires an enormous amount of time and effort.

The present invention has been conceived in light of the above circumstances, and the purpose is to offer a technique for realizing selection of an order recipient without increasing the processing load on a design system or increasing costs, and also realizing reduction in a human load relating to parts order placement.

### SOLUTION TO PROBLEM

To solve the above problem, the manufacturing ordering assistance apparatus, method and program according to the first embodiment of the present embodiment are configured such that the manufacturing ordering assistance apparatus capable of transmitting data by way of a network between a first terminal used by a product manufacturer and second terminals used by parts manufacturers acquires design information of a product from the first terminal; identifies information relating to parts from the acquired design information; generates, for the respective parts, parts manufacturing information necessary to manufacture the parts based on the identified information relating to the parts; and selects a parts manufacturer as an order recipient for the respective parts based on the generated parts manufacturing information and information relating to manufacturing capacities of the parts manufacturers.

According to the first aspect of the present invention, the processes for acquiring design information from product manufacturers, generating information necessary for manufacturing parts in accordance with the design information, and selecting a parts manufacturer as an order recipient are automatically performed on a manufacturing ordering assistance apparatus provided on a network. This eliminates the need to install functions such as those for generating information necessary for manufacturing parts and placing orders for the parts onto the design system of a product manufacturer, and thereby prevents the processing load on the design system and costs from increasing. This also eliminates the need for the personnel at respective product manufacturers to establish initial settings for the functions of the design system by acquiring manufacturing capacity information in advance from multiple parts manufacturers who can be possible order recipients, and to regularly update such settings. As a result, the human workload of a product manufacturer can be lightened, and operational efficiency can be enhanced.

### ADVANTAGEOUS EFFECTS OF INVENTION

That is, according to one aspect of the present invention, a technique can be offered with which an order recipient can be selected without increasing the processing load on a design system or increasing costs, and a human workload in a product manufacturer relating to parts order placement can be reduced.

### BRIEF DESCRIPTION OF THE DRAWINGS

FIG. 1 is a diagram for showing the overall configuration of a system including a manufacturing ordering assistance apparatus according to one embodiment of the present invention.
FIG. 2 is a block diagram for showing a hardware configuration of the manufacturing ordering assistance apparatus according to the embodiment of the present invention.
FIG. 3 is a block diagram for showing a software configuration of the manufacturing ordering assistance apparatus according to the embodiment of the present invention.
FIG. 4 is a flowchart for showing the procedure of the overall manufacturing ordering assistance process performed by the manufacturing ordering assistance apparatus illustrated in FIG. 3 as well as the details of the process.
FIG. 5 is a diagram showing an exemplary parts manufacturing information generating process in the flowchart of FIG. 4.
FIG. 6 is a diagram showing an exemplary matching process in the flowchart of FIG. 4.
FIG. 7 is a diagram showing an exemplary estimating and ordering process in the flowchart of FIG. 4.

### DETAILED DESCRIPTION

Embodiments of the present invention will be described below with reference to the drawings.

### [Embodiment]

### (Configuration Examples)

### (1) System

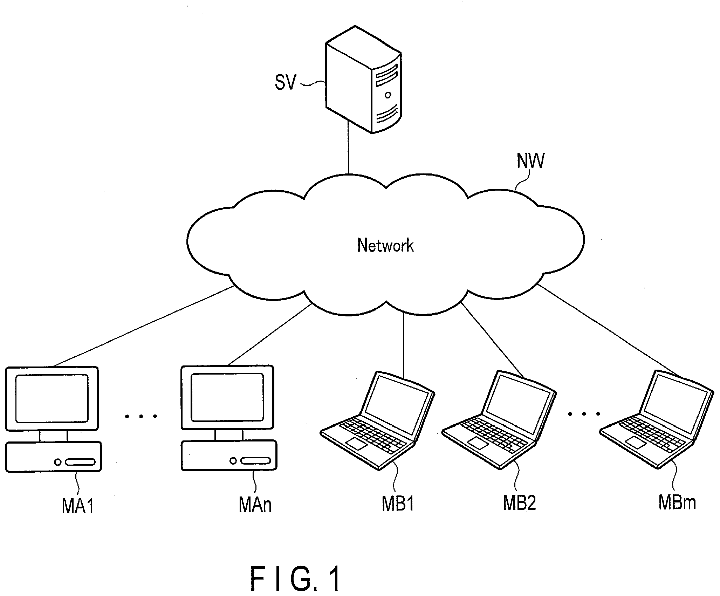

FIG. 1 is a diagram for showing the overall configuration of a system including a manufacturing ordering assistance apparatus according to one embodiment of the present invention.

In this example, the system is provided with a server computer (hereinafter referred to as a "server") SV, which operates as a manufacturing ordering assistance apparatus. The server SV realizes data transmission through a network NW between first terminals MA1 to MAn individually used by product manufacturers (also referred to as "assembly makers") and second terminals MB1 to MBm individually used by parts manufacturers (also referred to as "parts makers" or "processing agents").

The first terminals MA1 to MAn are, for example, CAD design systems or personal computers. The first terminals MA1 to MAn are used for transmitting, to the server SV, design information of a product generated by an engineer of the product manufacturer, supplemental information necessary for manufacturing of a part to be used, order placement information including various requests (or preferences) relating to the order of the part to be used, and the like, and for receiving estimate information and the like transmitted from the server SV.

The second terminals MB1 to MBm may be personal computers, and are used for transmitting, to the server SV, manufacturing resource information indicating the manufacturing capacity of respective parts manufacturers, and for receiving parts order-form information transmitted from the server SV.

The network NW may include a wide area network with the Internet serving as its mainstay and an access network for accessing this wide area network. Examples for an access network to be used may include a wired or wireless public network, a wired or wireless local area network (LAN), and a cable television (CATV) network.

### (2) Apparatus

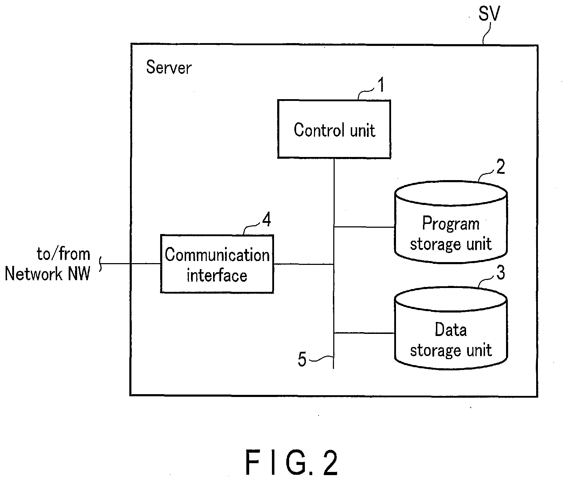

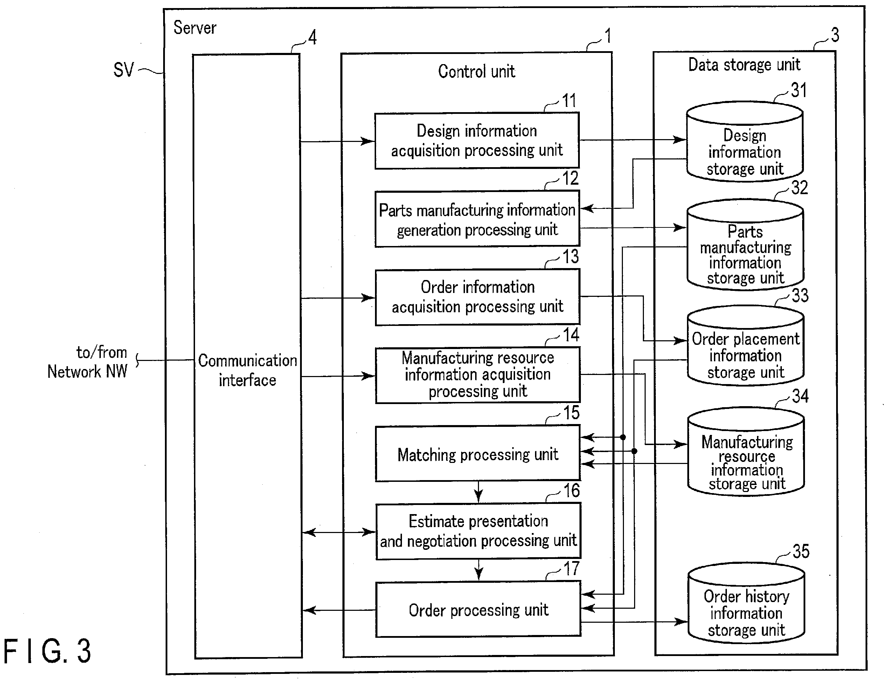

FIGS. 2 and 3 are block diagrams showing the hardware configuration and software configuration, respectively, of the server SV.

The server SV includes a control unit 1 having a hardware processor such as a Central Processing Unit (CPU), and this control unit 1 is connected, by way of the bus 5, to a storage unit including a program storage unit 2 and a data storage unit 3, and to a communication interface 4.

The communication interface 4 realizes data transmission between the first terminals MA1 to MAn and the second terminals MB1 to MBm via the network NW under the control of the control unit 1, and may be constituted by an interface for a wired network.

The program storage unit 2 is configured, for example, by combining a nonvolatile memory upon which writing and reading can be performed at any time, such as a hard disk drive (HDD) or solid state drive (SSD), and a nonvolatile memory such as a read only memory (ROM), as a storage medium. In addition to middleware such as an operating system (OS), the program storage unit 2 stores programs necessary to execute various controlling processes relating to the embodiment of the present invention.

The data storage unit 3 may be configured, for example, by combining a nonvolatile memory upon which writing and reading can be performed at any time such as an HDD or SSD, and a volatile memory such as a random access memory (RAM), as a storage medium. The data storage unit 3 includes, as main storage regions necessary to realize the embodiment of the present invention, a design information storage unit 31, a parts manufacturing information storage unit 32, an order placement information storage unit 33, a manufacturing resource information storage unit 34, and an order history information storage unit 35.

The design information storage unit 31 is used for storing design information uploaded by the first terminals MA1 to MAn of the product manufacturers and attribute information of the product manufacturers. The design information may include an assembly drawing and specification information of a product. An assembly drawing may include portable document format (PDF) data, and two-dimensional (2D) CAD data or three-dimensional (3D) CAD data. The specification information may include product identification information, quantities, dimensions, materials, hardness, and surface treatment types, and also include dimensions of parts and the like. The attribute information may include an entry time/date, a name of the product manufacturer, a name of the department, a name of a person who has made the entry, and an email address.

The parts manufacturing information storage unit 32 is used for storing parts manufacturing information necessary for manufacturing parts, which is generated by the later-described control unit 1. Examples of parts manufacturing information will be described later.

The order placement information storage unit 33 is used for storing parts order placement information acquired from the first terminals MA1 to MAn of the product manufacturers. The parts order placement information indicates various requests (or preferred conditions) regarding the parts order placement, which may include identification information of a part, a category and model of the part, a requested quantity, a requested production man-hour unit cost, a requested delivery date, and the like.

The manufacturing resource information storage unit 34 is used for storing manufacturing resource information of the parts manufacturers acquired from the second terminals MB1 to MBm of the parts manufacturers. The manufacturing resource information indicates the manufacturing capacities of the parts manufacturers, which may include types of processing techniques that can be offered by the parts manufacturers, processing costs, names of holding facilities, names of facilities able to operate, engineers able to operate, and the like.

The order history information storage unit 35 is used for storing the order-form information generated by the later-described control unit 1 in association with the order dates. This order history information stored in the order history information storage unit 35 is used for later analysis of accuracy in the selection of a parts manufacturer and the like.

The control unit 1 includes, as the processing functions according to the embodiment of the present invention, a design information acquisition processing unit 11, a parts manufacturing information generation processing unit 12, an order information acquisition processing unit 13, a manufacturing resource information acquisition processing unit 14, a matching processing unit 15, an estimate presentation and negotiation processing unit 16, and an order processing unit 17. These processing units 11 to 17 are realized by causing the hardware processor of the control unit 1 to execute respective programs stored in the program storage unit 2.

The design information acquisition processing unit 11 receives the design information and attribute information of products uploaded by the first terminals MA1 to MAn of the product manufacturers via the communication interface 4. Thereafter, the design information acquisition processing unit 11 executes a process of storing the received design information in the design information storage unit 31 in association with the identification information of a product manufacturer defined in the simultaneously received attribute information and identification information of a product.

The parts manufacturing information generation processing unit 12 includes functions of executing the following processes of:
(1) Reading the design information for respective products from the design information storage unit 31; recognizing the solid geometry, dimensions (size) and the like of each structural part based on the assembly drawing and specification information included in the design information; creating a parts drawing for each structural part from the recognized solid geometry and dimensions; and transmitting the generated parts drawings of the structural parts to the first terminals MA1 to MAn of the product manufacturers who have uploaded the above design information, where the parts drawings may be represented by 3D models.
(2) Identifying the type of a part based on the solid geometry of each structural part with reference to parts catalog information which defines the relationship of the geometries and types of parts, and generating a parts list, which is a list of the identified structural parts, where the parts catalog information may be prestored in a standard information storage unit (not shown) of the data storage unit 3, or may be browsed by accessing a web site on an as-needed basis.
(3) Creating a fabrication drawing for order placement for each structural part listed in the parts list, based on its parts drawing and supplemental information transmitted from the first terminals MA1 to MAn of the product manufacturer, where the supplemental information designates various types of conditions necessary for creating a fabrication drawing of a part, including the quality of the material, hardness, dimensions of various portions, type of surface treatment and the like. The fabrication drawing may be prepared by a 3D drawing, but a 2D drawing may be additionally created as needed.

In the creation of the fabrication drawing, a process of determining whether or not the conditions included in the supplemental information provide suitable values is executed based on the manufacturing condition standard information, where the manufacturing condition standard information may be prestored in the standard information storage unit (not shown) of the data storage unit 3, or may be browsed by accessing a web site on an as-needed basis.

(4) Identifying details of the processing necessary to produce parts in the fabrication drawing with reference to the information regarding the parts processing technique, and designing a processing process based on a comparison of the identified processing details and the supplemental information, where the design data of the processing process includes the identification information and category of the parts, quantities, models, and information indicating the processing details and processing sequence; the information relating to the parts processing technique includes the identification information and category of the parts, and information indicating the processing details and processing sequence; and the information relating to the parts processing technique may be prestored in the standard information storage unit (not shown) of the data storage unit 3, or may be browsed by accessing a web site on an as-needed basis.

(5) Storing, as parts manufacturing information, the created fabrication drawing of the parts and design data of the processing process in the parts manufacturing information storage unit 32 in association with the identification information of the product manufacturer and the identification information of the product and parts.

The order information acquisition processing unit 13 executes a process of receiving parts order placement information transmitted from the first terminals MA1 to MAn of the product manufacturers via the communication interface 4, and storing the received order placement information in the order placement information storage unit 33 in association with the identification information of the product manufacturer and product and the identification information of the part.

The manufacturing resource information acquisition processing unit 14 executes a process of receiving the manufacturing resource information of the parts manufacturers transmitted from the second terminals MB1 to MBm of the parts manufacturers via the communication interface 4, and storing the received manufacturing resource information, in association with the identification information of the parts manufacturers in the manufacturing resource information storage unit 34.

The matching processing unit 15 includes functions of executing the following processes:
(1) Reading the order placement information of individual parts from the order placement information storage unit 33 and also reading the manufacturing resource information of individual parts manufacturers from the manufacturing resource information storage unit 34; sequentially matching the order placement information with the manufacturing resource information of the parts manufacturers; selecting parts manufacturers capable of providing manufacturing resources that can satisfy the conditions described in the order placement information; and creating an order candidate list.
(2) Calculating the production price and the earliest delivery date for each parts manufacturer included in the created order candidate list, based on their manufacturing resource information and the requests in the order placement information; and generating estimate information, where the parts manufacturers on the order candidate list are sorted in accordance with the calculated production price and earliest delivery date.

The estimate presentation and negotiation processing unit 16 includes functions of executing the following processes:
(1) Transmitting the order candidate list generated for each part by the matching processing unit 15 and the estimate information through the communication interface 4 to the first terminal of the product manufacturer in question; receiving, via the communication interface 4, an order candidate list sorting condition transmitted from the first terminal of this destination product manufacturer; and sorting the parts manufacturers on the order candidate list in accordance with the received sorting condition, where, for example, three items including maximum manufacturing quantity, price, and delivery date may be presented so that the product manufacturer can freely set the sorting conditions in relation to these items.
(2) Sequentially selecting the order candidate parts manufacturers in accordance with the order candidate list; transmitting estimate information to the second terminals of the selected parts manufacturers; and also transmitting the same estimate information to the first terminal of the product manufacturer so as to mediate the order placement/intake negotiations between the two.
(3) Upon receipt of a notification indicating an agreement reached between the two as a result of the order placement/intake negotiations, determining this parts manufacturer as an order recipient; and generating order-form information based on the fabrication drawing of the part and the design data of the processing process created by the parts manufacturing information generation processing unit 12, the order placement information transmitted from the first terminal of the product manufacturer, and the information indicating the price, delivery date, and quantity agreed upon through the order placement/intake negotiation process, where the order-form information may include the fabrication drawings, design data of the processing process, price, delivery date, and quantity.

The order processing unit 17 executes a process of transmitting the order-form information generated by the estimate presentation and negotiation processing unit 16 to the second terminal of the corresponding parts manufacturer through the communication interface 4, and storing it in the order history information storage unit 35.

### (Exemplary operations)

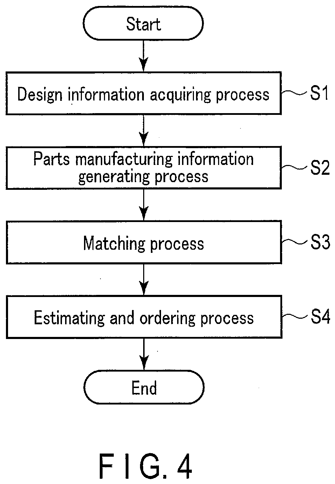

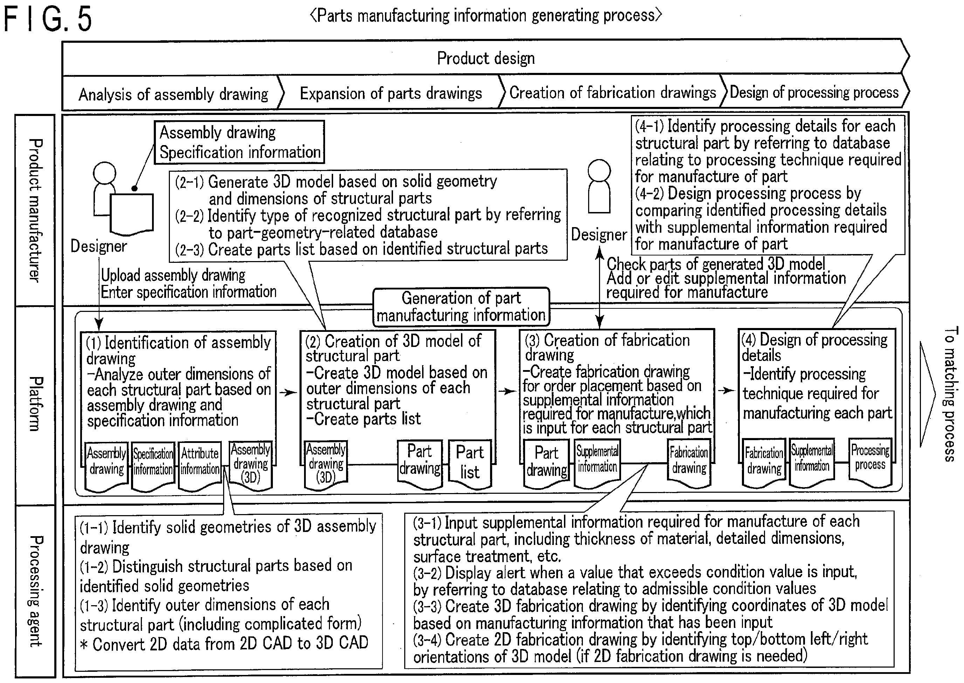

Next, exemplary operations of the above configured apparatus will be described. FIG. 4 is a flowchart showing the procedure of the overall manufacturing ordering assistance process performed by the server SV, and FIGS. 5 to 7 are diagrams showing specific examples of the parts manufacturing information generating process, matching process, and estimating and ordering process, respectively.

### (I) Acquisition of design information

First, under the control of the design information acquisition processing unit 11, the server SV executes a process of acquiring the design information of a product from a product manufacturer at step S1.

For instance, it is assumed that a product manufacturer, which creates an assembly drawing of a product using a CAD design system and also creates specification information of the product, may transmit the design information including this assembly drawing and specification information from the first terminal MA1, together with the attribute information of the product manufacturer.

The server SV receives, via the communication interface 4, the design information and attribute information transmitted from the first terminal MA1. Then, the server SV stores the received design information in the design information storage unit 31 in association with the identification information of the product manufacturer included in the simultaneously received attribute information. Similarly, when design information is transmitted from the first terminals MA2 to MAn of other product manufacturers, the server SV executes the process of acquiring the design information under the control of the design information acquisition processing unit 11.

### (II) Generation of parts manufacturing information

Under the control of the parts manufacturing information generation processing unit 12, the server SV executes the process of generating parts manufacturing information at step S2 in the following manner. FIG. 5 shows the flow of the process and specific examples thereof.

### (1) Identification of assembly drawing

First, the parts manufacturing information generation processing unit 12 reads design information for respective products from the design information storage unit 31, and identifies the solid geometry of each structural part based on the assembly drawing included in the design information, for example by using pattern matching (1-1). Then, the structural parts are distinguished based on the identified solid geometries (1-2). Next, the parts manufacturing information generation processing unit 12 identifies the dimensions of each structural part, based on the specification information included in the design information (1-3). If the assembly drawing included in the design information is 2D CAD drawing data, the parts manufacturing information generation processing unit 12 converts it to 3D CAD drawing data.

### (2) Creation of parts drawing and parts list

Thereafter, the parts manufacturing information generation processing unit 12 creates a parts drawing including a 3D model of the structural parts, based on the solid geometry and dimensions of each of the distinguished structural parts (2-1). Then, based on the geometry of each structural part, the parts manufacturing information generation processing unit 12 identifies the type of the structural part (2-2). This identification process is performed, for example, by referring to the parts catalog information downloaded in advance from a web site and stored in the data storage unit 3. The parts catalog information defines the relationship between the geometry and type of each part. Based on the identified types of the structural parts, the parts manufacturing information generation processing unit 12 generates a parts list, which is a list of parts used in the product (2-3). The parts list may describe, for example, the identification information and category of a part, and the quantity, model (preferably numbered), and arrangement coordinates for each part.

### (3) Creation of parts fabrication drawing

Next, the parts manufacturing information generation processing unit 12 acquires the supplemental information transmitted from the first terminals MA1 to MAn of the product manufacturers (3-1). The supplemental information may include various conditions necessary for manufacturing the parts, including the quality of the material, hardness, dimensions of various portions, type of surface treatment, and the like. Thereafter, the parts manufacturing information generation processing unit 12 determines whether or not the conditions included in the supplemental information indicate suitable values, based on the manufacturing condition standard information. If the conditions of the supplemental information include one that will not satisfy the standard, the parts manufacturing information generation processing unit 12 generates alarm information and transmits it to the first terminal MA1 (3-2). The manufacturing condition standard information may be downloaded in advance from a web site and stored in the data storage unit 3.

Next, the parts manufacturing information generation processing unit 12 creates a 3D fabrication drawing for each of the structural parts described in the parts list, based on the 3D parts drawing of the part and supplemental information. This process may be executed by identifying the coordinate values from the 3D parts drawing, and using these coordinate values and the thickness and dimensions of the material designated in the supplemental information (3-3). If 2D drawing data is required in addition to 3D drawing data, a 2D fabrication drawing may be created by identifying the top/bottom left/right orientations of the 3D fabrication drawing and projecting the drawing onto a flat plane and side plane (3-4). The data of the parts fabrication drawing may be in a PDF format.

### (4) Design of processing process

Thereafter, the parts manufacturing information generation processing unit 12 identifies processing details (a processing technique) required to manufacture the parts in the fabrication drawing by referring to the information regarding the parts processing technique (4-1). For the information regarding the parts processing technique, the information downloaded in advance from a web site and stored in the data storage unit 3 may be used. Then, the parts manufacturing information generation processing unit 12 designs the processing process by comparing the identified processing details with the supplemental information (4-2). The design data of the processing process includes the identification information and category of the parts, and the quantity, model, and information indicating the processing types and processing sequence.

The server SV temporarily stores the parts fabrication drawing and design data of the processing process generated by the parts manufacturing information generation processing unit 12 as parts manufacturing information in the parts manufacturing information storage unit 32, in association with the identification information of the product manufacturer and identification information of the product and parts.

### (III) Matching process

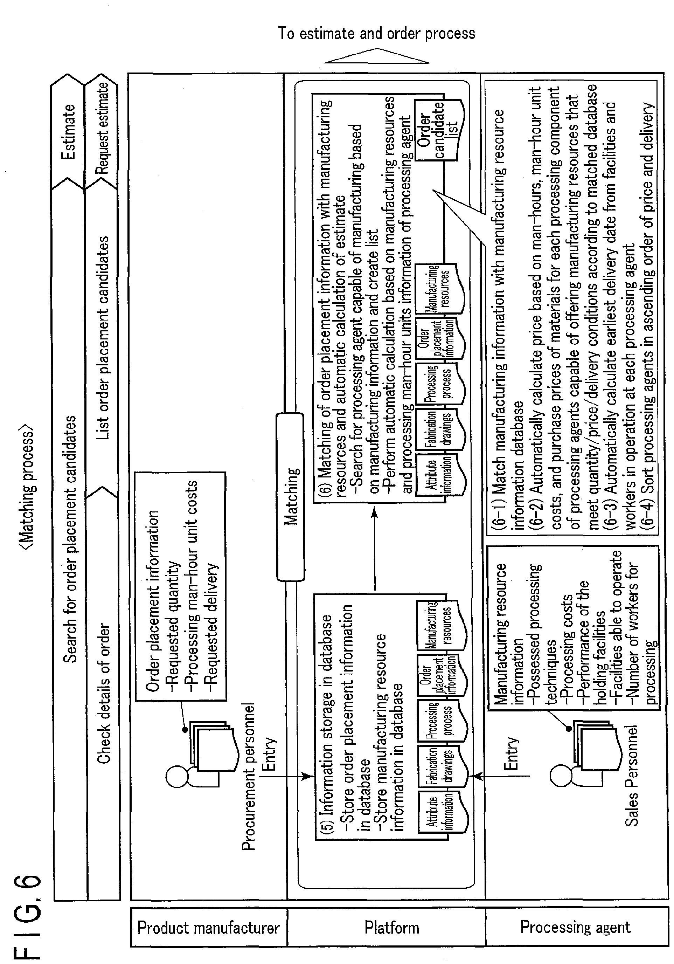

Thereafter, the server SV executes the following processes for selecting parts manufacturers who can be candidates for order placement at step S3. FIG. 6 shows the flow of the process and specific examples thereof.

### (5) Acquisition of order placement information and manufacturing resource information

At a product manufacturer, the procurement personnel may generate order placement information for each part, and transmit the information from the first terminal MA1 to the server SV. The order placement information may include the identification number of the part, requested quantity, production man-hour unit cost, and requested delivery date. On the other hand, under the control of the order information acquisition processing unit 13, the server SV receives via the communication interface 4 the order placement information transmitted from the first terminal MA1 of the product manufacturer, and stores the received order placement information in the order placement information storage unit 33.

On the other hand, at each parts manufacturer, the sales personnel may create manufacturing resource information indicating the manufacturing capacity of their company, and transmit the created manufacturing resource information from the second terminals MB1 to MBm to the server SV. The manufacturing resource information includes types of the processing techniques offered by the parts manufacturer, processing unit costs, performance of the holding facilities, number of facilities able to operate, number of workers for the processing, and the like. Under the control of the manufacturing resource information acquisition processing unit 14, the server SV receives via the communication interface 4 the manufacturing resource information transmitted from the second terminals MB1 to MBm of the parts manufacturers, and stores the received manufacturing resource information in the manufacturing resource information storage unit 34.

### (6) Matching of order placement information and manufacturing resource information and calculation of estimate

Under the control of the matching processing unit 15, the server SV first reads the order placement information for each part from the order placement information storage unit 33. The server SV further reads the manufacturing resource information of each parts manufacturer from the manufacturing resource information storage unit 34. By sequentially comparing the order placement information with the manufacturing resource information of each parts manufacturer, all the parts manufacturers who can provide manufacturing resources that can satisfy the conditions requested in the order placement information, including the requested quantity, production man-hour unit cost, and requested delivery date, are selected, and thereby an order candidate list is created (6-1). The order candidate list includes information indicating the names of the parts manufacturers capable of manufacturing the part, the maximum manufacturing quantity for each parts manufacturer, estimated production price, and possible delivery date.

For each of the parts manufacturers included in the order candidate list, the matching processing unit 15 calculates the production price from the man-hours for each structural component and per-unit costs for man-hours, and the purchase expense of the materials, based on the manufacturing resource information and the conditions of the order placement information (6-2).

The matching processing unit 15 further calculates the earliest delivery date of the respective parts manufacturers included in the order candidate list, based on the number of facilities able to operate, the performance of the facilities, and the number of workers for the processing included in the manufacturing resource information (6-3).

Lastly, the matching processing unit 15 sorts the parts manufacturers in the order candidate list based on the calculated production price and the earliest delivery date (6-4). The sorted order candidate list and estimate information of each parts manufacturer on this list are passed along to the estimating and ordering process.

### (IV) Estimate and order process

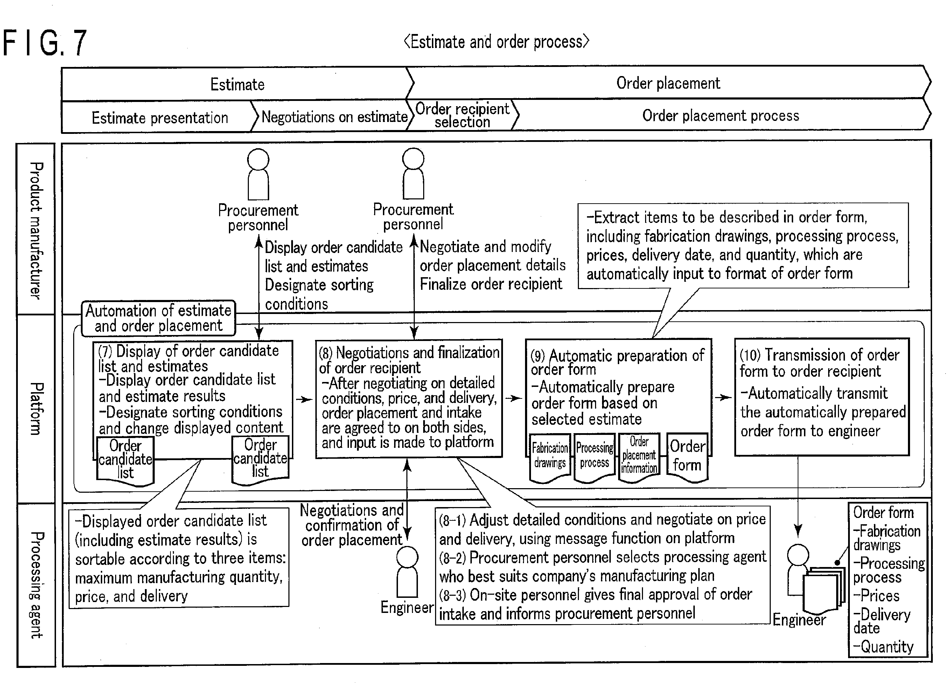

The server SV executes the estimating and ordering process at step S4, as indicated below. FIG. 7 shows the flow of the process and specific examples thereof.

### (7) Presentation of order candidate list and estimate

First, under the control of the estimate presentation and negotiation processing unit 16, the server SV transmits the order candidate list and estimate information of each parts manufacturer passed along from the matching processing unit 15, through the communication interface 4 to the first terminal MA1 of the product manufacturer. In this manner, the procurement personnel of the product manufacturer can check the parts order candidate list and the estimate information of the parts manufacturers on the list.

In response to the procurement personnel of the product manufacturer transmitting a sorting condition for the order candidate list from the first terminal MA1 to the server SV, the server SV sorts the parts manufacturers on the order candidate list under the control of the estimate presentation and negotiation processing unit 16. For instance, when the procurement personnel freely places designations for the three items of the maximum manufacturing quantity, production price, and delivery date, the estimate presentation and negotiation processing unit 16 sorts the parts manufacturers on the order candidate list in descending order of favorable conditions with regard to the designated items.

### (8) Assist in estimate negotiations

Under control of the estimate presentation and negotiation processing unit 16, the server SV executes a mediating process to assist negotiations between the product manufacturer and respective parts manufacturers on the order placement/intake. For instance, the estimate presentation and negotiation processing unit 16 transmits to the first terminal MA1 of the product manufacturer the estimate information of the parts manufacturer positioned at the very top of the sorted order candidate list. Furthermore, the estimate presentation and negotiation processing unit 16 transmits this estimate information to the second terminal MB1 of the parts manufacturer positioned at the very top. This enables negotiations between the procurement personnel of the product manufacturer and engineers of the parts manufacturer with regard to the order placement/intake.

For the procedure of the negotiations, the server SV may provide a message exchange function such as a chat function so that negotiation data can be exchanged between the first terminal MA1 and second terminal MB1.

For instance, the server SV executes the process (8-1) of displaying the detailed conditions, price, and delivery date input on the first and second terminals by the procurement personnel of the product manufacturer and the engineers of the parts manufacturer, using the message exchange function of the server SV, in a browsable manner from the two sides, and the processes (8-2) and (8-3) of, when the procurement personnel of the product manufacturer selects a preferable parts manufacturer from the order candidate list, transmitting the estimate information of this parts manufacturer to the first terminal of the product manufacturer and the second terminal of the parts manufacturer to allow for negotiations, and relaying the results of the negotiations.

### (9) Preparation of order form

As a result of the order placement/intake negotiations, if the procurement personnel of the product manufacturer and the processing engineers of the parts manufacturer reach an agreement for the order placement/intake, the server SV executes a process of preparing an order form under the control of the order processing unit 17.

The order processing unit 17 has a format for an order form, for instance, and prepares an order form by inserting into this format data such as the name of the parts manufacturer as the order recipient, the name and address of the product manufacturer as the order placer and the name of their representative, identification information of the part, the parts fabrication drawing, and the design data of the processing process stored in the parts manufacturing information storage unit 32, the price, the delivery date, and the quantity agreed in the negotiations of the order placement/intake.

### (10) Transmission of order form

Under the control of the order processing unit 17, the server SV transmits the information of the order form generated by the estimate presentation and negotiation processing unit 16 through the communication interface 4 to the second terminal of the parts manufacturer who is the order recipient. The order processing unit 17 also stores the information of this order form in the order history information storage unit 35 in association with the order date. By using the order history information in this order history information storage unit 35, the server SV may analyze the accuracy in the selection of a parts manufacturer.

### (Functions and Effects)

As described above, according to the present embodiment, the server SV is configured to acquire design information from the first terminals MA1 to MAn of product manufacturers, identify structural parts of a product based on an assembly drawing and specification information included in the acquired design information, generate a parts list, which indicates a list of the structural parts, and a parts drawing of each part, and further generate parts fabrication drawings and design data of the processing process based on the parts drawings and conditions of the parts requested as supplemental information by a product manufacturer. In addition, the server SV is configured to select parts manufacturers capable of providing manufacturing resources that can satisfy the conditions of the order placement information through comparison of the order placement information designated by the product manufacturer sequentially with the manufacturing resource information of respective parts manufacturers, create an order candidate list, create an order form for a parts manufacturer determined as an order recipient through negotiations between the product manufacturer and the parts manufacturers on the order candidate list, and transmit the order form to their second terminal.

As a result, a series of operations can be automatically executed at the server SV located on the network NW, from identifying structural parts based on the design information transmitted from a product manufacturer and generating parts manufacturing information to selecting a parts manufacturer as an order recipient for a part and transmitting an order form thereto. Thus, there is no need for individual product manufacturers to have a CAD design system equipped with functions of generating parts manufacturing information and selecting an order recipient of a part and placing an order with them, which prevents the processing load on the CAD design system from increasing and also prevents costs from increasing. Furthermore, personnel at each product manufacturer do not need to acquire manufacturing capacity information in advance from multiple parts manufacturers who can be possible order recipients and establish initial settings for the functions of the design system, or to regularly update the settings. Thus, the human workload of a product manufacturer can be lightened, and operational efficiency can be enhanced.

### [Other Embodiments]

(1) In the process of generating the parts manufacturing information, a trained model may be adopted to realize the creation of parts drawings and parts lists by inputting the solid geometries and specification information of the identified parts. In addition, the creation of parts fabrication drawings and design data of the processing process by inputting the parts drawings, supplemental information, and processing technique information may also be realized with a trained model.
(2) In the estimate presentation and negotiation process, a process of comparing the favorable price and delivery date presented by the product manufacturer with the favorable price and delivery date presented by each parts manufacturer on the order candidate list, selecting a parts manufacturer with the smallest difference, and indicating this parts manufacturer to the product manufacturer may be executed. A process of indicating the aforementioned differences to the product manufacturer and parts manufacturers and urging them to input modified values, and indicating a parts manufacturer with the smallest difference to the product manufacturer may also be executed.
(3) In the above embodiment, selection of a parts manufacturer as an order recipient has been explained as relying on negotiations between the product manufacturer and each parts manufacturer. The server SV, however, may be configured to compare the order placement admissibility conditions transmitted from the first terminal of the product manufacturer in response to the presentation of the estimate information with the order intake admissibility conditions transmitted from the second terminal of the parts manufacturer; determine whether or not the difference between the order placement admissibility conditions and the order intake admissibility conditions falls within a predetermined range; based on the result of the determination, select a parts manufacturer with the matched conditions as an order recipient; and inform the first terminal of the product manufacturer.
(4) According to the above embodiment, an example has been explained in which order-form information including parts fabrication drawings, design information of the processing process, order quantity, price, and delivery date is generated and transmitted to the second terminal. The order-form information may be configured to include at least parts fabrication drawings and design information of the processing process, while information indicating the order quantity, price, and delivery date may be reported to the parts manufacturer by way of a separate notification means.
(5) In addition to the above, various modifications may be made to the configuration and installation location of the manufacturing ordering assistance apparatus, the processing sequence and details of the parts manufacturing information generating process, the matching process, and the estimating and ordering process, without departing from the scope of the present invention.

The embodiments of the present invention have been explained above in detail, and are mere examples of the present invention in every aspect. Various improvements and modifications can be added without departing from the scope of the invention. That is, a specific configuration corresponding to an embodiment may be suitably adopted for the implementation of the present invention.

The present invention should not be limited to the above-described embodiments as-is, but may be embodied by modifying the structural elements without departing from the scope of the invention at the implementation stage. In addition, various inventions may be constituted by appropriately combining a plurality of structural elements disclosed in the embodiments. For example, some of the structural elements shown in the embodiments may be omitted. Furthermore, the structural elements of different embodiments may be suitably combined.

### REFERENCE SIGNS LIST

- SV: Server
- MA1 to MAn: First terminals of product manufacturers
- MB1 to MBm: Second terminals of parts manufacturers
- NW: Network
- 1: Control unit
- 2: Program storage unit
- 3: Data storage unit
- 4: Communication interface
- 5: Bus
- 11: Design information acquisition processing unit
- 12: Parts manufacturing information generating processing unit
- 13: Order information acquisition processing unit
- 14: Manufacturing resource information acquisition processing unit
- 15: Matching processing unit
- 16: Estimate presentation and negotiation processing unit
- 17: Order processing unit
- 31: Design information storage unit
- 32: Parts manufacturing information storage unit
- 33: Order information storage unit
- 34: Manufacturing resource information storage unit
- 35: Order history information storage unit

## Claims

1. A manufacturing ordering assistance apparatus capable of transmitting data by way of a network between a first terminal used by a product manufacturer and second terminals used by parts manufacturers, the apparatus comprising:
an acquisition unit configured to acquire design information of a product from the first terminal;
a parts manufacturing information generation unit configured to identify information relating to parts from the acquired design information and generate, for the respective parts, parts manufacturing information necessary to manufacture the parts based on the identified information relating to the parts; and
a selection unit configured to select a parts manufacturer as an order recipient for the respective parts based on the generated parts manufacturing information and information relating to manufacturing capacities of the parts manufacturers.

2. The manufacturing ordering assistance apparatus according to claim 1, further comprising:
an order placement unit configured to generate order-form information of the parts based on the parts manufacturing information, and transmit the generated order-form information to a second terminal used by the selected parts manufacturer.

3. The manufacturing ordering assistance apparatus according to claim 1, wherein the parts manufacturing information generation unit is configured to execute:
a first process of identifying geometries and sizes of parts that constitute the product, based on an assembly drawing of the product included in the design information and specification information of the parts; and
a second process of generating fabrication drawings of the parts and design information of a processing process for each of the parts, based on the geometries and sizes of the parts and conditions necessary to manufacture the parts designated by the product manufacturer, and adopting the generated fabrication drawings and the design information of the processing process as the parts manufacturing information.

4. The manufacturing ordering assistance apparatus according to claim 3, wherein the second process includes:
a process of creating a three-dimensional or two-dimensional parts drawing of the parts based on the geometries and sizes of the parts and outputting the created parts drawing to the first terminal; and
a process of acquiring, in response to an output of the parts drawing, supplemental information indicating the conditions necessary to manufacture the parts from the first terminal.

5. The manufacturing ordering assistance apparatus according to claim 4, wherein the second process includes:
a process of acquiring information relating to a parts processing technique and determining processing details of the parts based on the acquired information relating to the parts processing technique; and
a process of generating information indicating the processing process based on the determined processing details and the supplemental information.

6. The manufacturing ordering assistance apparatus according to claim 1, wherein the selection unit is configured to execute:
a process of acquiring order placement condition information for the parts from the first terminal;
a process of acquiring parts-manufacturer manufacturing resources information from the second terminals; and
a process of comparing the acquired order placement condition information with the acquired parts-manufacturer manufacturing resources information, and selecting a parts manufacturer having manufacturing resources that satisfy conditions indicated in the order placement condition information for the parts.

7. The manufacturing ordering assistance apparatus according to claim 1, wherein the selection unit is configured to execute:
a process of selecting at least one parts manufacturer as a candidate order recipient of the parts, and generating estimate information relating to manufacturing of the parts for each of the selected parts manufacturers, based on the order placement condition information of the parts and the parts-manufacturer manufacturing resources information; and
a process of transmitting the estimate information for each of the parts manufacturers to the first terminal and the second terminal.

8. The manufacturing ordering assistance apparatus according to claim 2, wherein
the order placement unit generates, based on the parts manufacturing information and conditions necessary to manufacture the parts designated by the product manufacturer, the order-form information including at least the fabrication drawings of the parts and design information of a processing process from among the fabrication drawings of the parts, the design information of the processing process, and information indicating an order quantity, a price, and a delivery date.

9. A manufacturing ordering assistance method executed by an information processing apparatus capable of transmitting data by way of a network between a first terminal used by a product manufacturer and second terminals used by parts manufacturers, the method comprising:
acquiring design information of a product from the first terminal;
identifying information relating to parts from the acquired design information and generating, for the respective parts, parts manufacturing information necessary to manufacture the parts based on the identified information relating to the parts; and
selecting a parts manufacturer as an order recipient for the respective parts based on the generated parts manufacturing information and information relating to manufacturing capacities of the parts manufacturers.

10. The manufacturing ordering assistance method according to claim 9, further comprising:
generating order-form information of the parts based on the parts manufacturing information, and transmitting the generated order-form information to a second terminal used by the selected parts manufacturer.

11. A program for causing a hardware a hardware processor of the manufacturing ordering assistance apparatus according to any one of claims 1 to 8 to execute the processes of the respective units of the manufacturing ordering assistance apparatus.
